# EUROPEAN PATENT APPLICATION

(11) **EP 4 808 285 A1**
(43) Date of publication of application: **16.09.2026**
(21) Application number: 24888367.0
(22) Date of filing: 30.08.2024
(51) Int. Cl.: H05K 1/02, H01L 23/12, H05K 1/09, H05K 3/32

(54) **CIRCUIT BOARD AND METHOD FOR PRODUCTION THEREOF**

(30) Priority: 10.11.2023 JP 2023192069
(71) Applicant: NHK Spring Co., Ltd., Yokohama-shi, Kanagawa 236-0004 (JP)
(72) Inventor: TANAKA, Ryo, Yokohama-shi Kanagawa 236-0004 (JP)
(74) Representative: Oppermann, Frank
(86) International application number: PCT/JP2024/031388
(87) International publication number: WO 2025/100065

(57) **Abstract**

Provided is a circuit board capable of performing connection of a conductive material to an additional metal layer by welding. The circuit board includes a circuit pattern 3 provided on an insulating layer 7, an additional metal layer 9 stacked and bonded on the circuit pattern 3, and a lead frame 11 stacked on the additional metal layer 9 and connected to the additional metal layer by welding, wherein a total thickness of the additional metal layer 9 and the circuit pattern 3 in the stacking direction is 1.5mm to 3.0mm, and a thickness of the lead frame 11 in the stacking direction is 0.2mm to 1.2mm.

## Description

### FIELD OF THE INVENTION

The present invention relates to a circuit board used for a power device or the like, and a method for production thereof.

### BACKGROUND OF THE INVENTION

As a circuit board for large current used in a power device or the like, there is one that reduces thermal resistance by partially increasing a thickness of a circuit pattern. For example, in Patent Literature 1, a stacked circuit pattern is laminated on a circuit pattern as an additional metal layer in a portion where an electronic component such as a chip of a power semiconductor is attached. An electronic component is attached to the additional metal layer by soldering.

On the other hand, there is a demand in a circuit board for attaching a conductive member such as a lead frame by welding with a laser or soldering (laser solder) by locally heating or the like. Patent Literature 1, however, assumes attachment of an electronic component with solder, and cannot adapt for welding or laser solder at a higher temperature.

For this reason, if the conductive member is connected to the circuit pattern by welding for example, heat during the welding may be transmitted from the circuit pattern to an interface with respect to the insulating layer made of resin supporting the circuit pattern so that the insulating layer may be damaged.

### CITATION LIST

### PATENT LITERATURE

PATENT LITERATURE 1: 2006-319146

### SUMMARY OF THE INVENTION

### PROBLEMS TO BE SOLVED BY THE INVENTION

The problem to be solved is that it is not possible to adapt for increase in heat at the time of connection of a conductive member.

### MEANS FOR SOLVING THE PROBLEM

The present invention provides a circuit board including a circuit pattern provided on an insulating layer, an additional metal layer stacked and bonded on the circuit pattern, and a conductive member stacked on the additional metal layer and connected to the additional metal layer by welding, wherein a total thickness of the additional metal layer and the circuit pattern in the stacking direction is 1.5mm to 3.0mm, and a thickness of the conductive member in the stacking direction is 0.2mm to 1.2mm.

The present invention also provides a method for manufacturing a circuit board, the circuit board comprising a circuit pattern provided on an insulating layer, an additional metal layer stacked and bonded on the circuit pattern, and a conductive member stacked and connected on the additional metal layer, wherein a total thickness of the additional metal layer and the circuit pattern in the stacking direction is 1.5mm to 3.0mm, and a thickness of the conductive member in the stacking direction is 0.2mm to 1.2mm, stacking the conductive member on the additional metal layer and connecting the conductive member to the additional metal layer by laser welding.

### EFFECT OF THE INVENTION

The present invention suppresses damage to an insulating layer due to heat when a conductive member is connected.

### BRIEF DESCRIPTION OF THE DRAWINGS

[FIG. 1] FIG. 1 is a sectional view of a circuit board illustrating an attaching portion of a lead frame and a periphery thereof according to an embodiment 1 of the present invention.
[FIG. 2] FIG. 2 is a plan view of the circuit board of FIG. 1.
[FIG. 3] FIG. 3 is a schematic sectional view of a situation in which the additional metal layer is ultrasonically bonded to a circuit pattern.
[FIG. 4] FIG. 4 is an enlarged sectional view of a portion of a tool of FIG. 3 pressed against the additional metal layer.
[FIG. 5] FIG. 5 is a sectional view illustrating an experimental method according to the embodiment 1.
[FIG. 6] FIG. 6 is a graph plotting experimental results of FIG. 5.

### EMBODIMENT FOR CARRYING OUT THE INVENTION

The object of suppressing damage to an insulating layer due to heat when a conductive member is connected is accomplished by adjusting a thickness, in a stacking direction, of a portion to which a conductive member is connected in a circuit pattern and a thickness of the conductive member in the stacking direction.

The circuit board 1 includes a circuit pattern 3, an additional metal layer 9, and a conductive member 11. The circuit pattern 3 is provided on an insulating layer 7. The additional metal layer 9 is stacked and bonded on the circuit pattern 3. The conductive member 11 is stacked on the additional metal layer 9 and connected to the additional metal layer by welding.

A total thickness of the additional metal layer 9 and the circuit pattern 3 in the stacking direction is 1.5mm to 3.0mm, and a thickness of the conductive member 11 in the stacking direction is 0.2mm to 1.2mm.

In this case, respective thicknesses of the additional metal layer 9 and the circuit pattern 3 may be arbitrarily set as long as a sum thereof is 1.5mm to 3.0mm. As one embodiment, the thickness of the additional metal layer 9 in the stacking direction may be 0.7mm to 2.7mm, and the thickness of the circuit pattern 3 in the stacking direction may be 0.3mm to 0.8mm.

The method for manufacturing the circuit board 1 stacks the conductive member 11 on the additional metal layer 9 and connects the conductive member to the additional metal layer by laser welding.

In one embodiment, the method for manufacturing the circuit board 1 may press a tool T against a connecting surface 12 of the additional metal layer 9 to ultrasonically vibrate to stack and bond the additional metal layer 9 onto the circuit pattern 3. In this case, the conductive member 11 is stacked on the surface 12 of the additional metal layer 9 bonded on the circuit pattern 3 and is connected to the surface by laser welding.

### EMBODIMENT 1

### [Circuit Board]

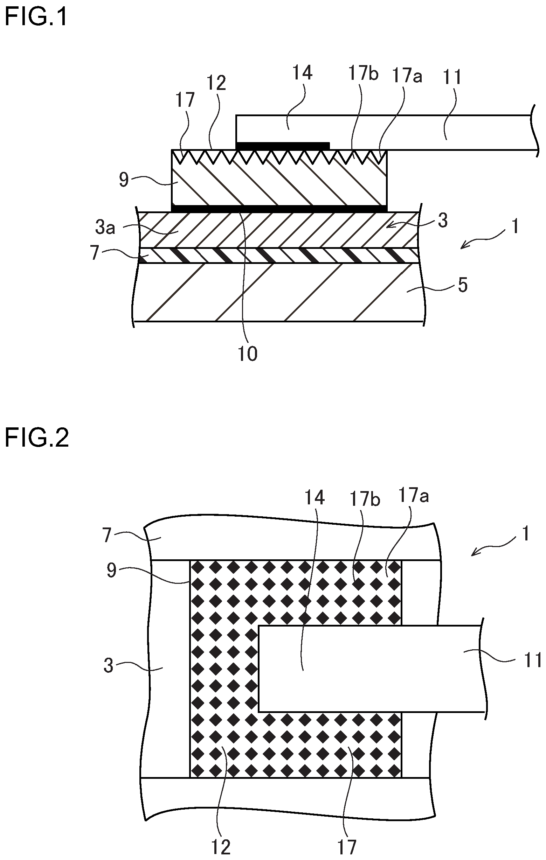

FIG. 1 is a sectional view of a circuit board illustrating an attaching portion of a lead frame and a periphery thereof according to the embodiment 1 of the present invention. FIG. 2 is a plan view of the circuit board of FIG. 1.

A circuit board 1 in FIGS. 1 and 2 is a circuit board for large current such as a power device. The circuit board 1 is a metal-based circuit board including a metal substrate 5 and an insulating layer 7, a circuit pattern 3, an additional metal layer 9, and a lead frame 11 as a conductive member.

The metal substrate 5 is formed of a plate-shaped body made of metal. In addition, the shape of the metal substrate 5 may be appropriately set and may adopt a heat sink shape.

Material of the metal substrate 5 may employ, for example, single metal or alloy such as aluminum, iron, copper, or stainless steel, and there is no limitation on the presence or absence of flexibility. The metal substrate 5 may further include a non-metal such as carbon. Further, the metal substrate 5 may contain aluminum composited with carbon. Further, the metal substrate 5 may have a single-layer structure or a multilayer structure.

Although a thickness of the metal substrate 5 may be appropriately set, the thickness of the metal substrate is set to, for example, 2.0mm. The metal substrate 5 has a high thermal conductivity. For example, it has a thermal conductivity of 370-400 W m -1 K -1 in the case of copper material, 190-220 W m -1 K -1 in the case of aluminum material, or 60-80 W m -1 K -1 in the case of iron material.

The insulating layer 7 is laminated on the metal substrate 5 and is formed in a plate shape. The insulating layer 7 functions to electrically insulate the circuit pattern 3 from the metal substrate 5 and also functions as an adhesive for bonding the circuit pattern 3 and the metal substrate 5 to each other. Accordingly, resin is generally used for the insulating layer 7. Although a thickness of the insulating layer 7 may be appropriately set, the thickness of the insulating layer is set to, for example, 0.13mm.

The insulating layer 7 of the present embodiment may be made of epoxy resin, cyanate resin, or the like. As the epoxy resin, for example, an amine-based curing agent, a phenol-based curing agent, an acid anhydride-based curing agent, or an imidazole-based curing agent are combined. For example, dicyandiamide or phenol resin is combined with the cyanate resin as a curing agent. Further, the insulating layer 7 may be made of liquid crystal polymer such as a wholly aromatic polyester which is thermoplastic resin, or other thermoplastic resin.

The insulating layer 7 preferably further contains inorganic fillers. As the inorganic fillers contained in the insulating layer 7, those having superior electrical insulating properties and high thermal conductivity are preferable. For example, as the inorganic fillers, alumina, silica, aluminum nitride, boron nitride, silicon nitride, magnesium oxide, and the like may be mentioned, and one or two or more selected from those may be preferably used.

A filling rate of the inorganic fillers in the insulating layer 7 may be appropriately set according to a type of the inorganic fillers. For example, it is preferably 85% by volume or less on the basis of a total volume of the resin contained in the insulating layer 7, and more preferably 30% to 85% by volume.

The insulating layer 7 may further contain, for example, a coupling agent, a dispersant, or the like. In addition, an insulating sheet in a semi-cured state may be used as the insulating layer 7.

The circuit pattern 3 is provided on the insulating layer 7. As a result, the circuit pattern 3 is provided on the insulating substrate being provided with the insulating layer 7 on the metal substrate 5. The circuit pattern 3 is a plate-shaped body or a foil, and is formed in a predetermined pattern by etching of a conductor 3a.

The circuit pattern 3 of the present embodiment is formed of a copper material which is a conductor for a circuit having a thickness of 0.3mm to 0.8mm, for example, 0.5mm. The circuit pattern 3 is constant in thickness except for a stacked portion of the additional metal layer 9. The thickness of the circuit pattern 3, however, may be varied.

In addition, the circuit pattern 3 may be formed of aluminum or the like. Further, the circuit pattern 3 may be one formed in advance by pressing or cutting without etching and stuck on the metal substrate 5 through the insulating layer 7.

The lead frame 11 as another member is connected to the circuit pattern 3 of the present embodiment. In a portion where the lead frame 11 is connected, the additional metal layer 9 is stacked and bonded so that the circuit pattern 3 is configured to be partially thick.

The additional metal layer 9 is formed in a plate shape. Although the additional metal layer 9 of the present embodiment is made of copper, it may be made of another conductor for a circuit such as aluminum. A planar shape of the additional metal layer 9 is, for example, a square of 10mm square. The planar shape of the additional metal layer 9, however, may be arbitrarily set.

A thickness of the additional metal layer 9 in the stacking direction is 0.7mm to 2.7mm. Although the thickness of the additional metal layer 9 in the stacking direction is larger than the thickness of the circuit pattern 3 in the stacking direction in this embodiment, the thickness of the additional metal layer in the stacking direction may be smaller than the thickness of the circuit pattern 3 in the stacking direction. The additional metal layer 9 has the constant thickness. A total thickness of the circuit pattern 3 and the additional metal layer 9 is 1.5mm to 3.0mm.

The additional metal layer 9 has a bonding surface 10, which is a bottom surface, with respect to the circuit pattern 3 on one side in the stacking direction, and has a connecting surface 12, which is a top surface, with respect to the lead frame 11 on the other side.

The bonding surface 10 is wholly bonded to the circuit pattern 3 in a range facing the circuit pattern in the stacking direction. The bonding is performed by ultrasonic welding. The connecting surface 12 is a portion to which the lead frame 11 is connected or bonded by laser welding. The connecting surface 12 includes an uneven portion 17. In the present embodiment, the uneven portion 17 is provided on the whole surface of the connecting surface 12. The whole surface should be substantially the whole surface, and includes a case that a part or whole of an outer peripheral region of the connecting surface 12 is flat.

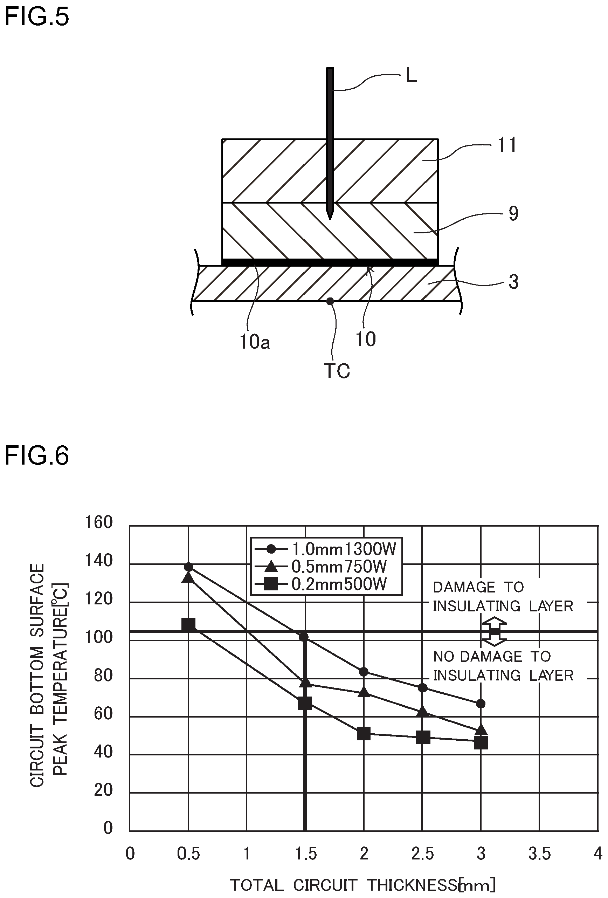

This uneven portion 17 is formed by means of a tool uneven portion 15 (to be explained later with reference to FIG. 5) of a tool T (to be explained later with reference to FIG. 5) for vibration transmission to bond the additional metal layer 9 on the circuit pattern 3 by ultrasonic vibration in the planar direction.

Although the uneven portion 17 may have various planar shapes and sectional shapes, the uneven portion is provided with engagement recesses 17a and engagement projections 17b in any case. Although the intervals and sizes of the engagement recesses 17a and the engagement projections 17b are regularly set to be constant, the intervals and sizes may also be set at random.

Each engagement recess 17a of the uneven portion 17 is formed in a quadrangular shape in a plan view and in an inverted square pyramid shape in a cross section. The uneven portion 17 is not particularly limited and may be a recess or the like formed by a curved surface in shape of the engagement recess 17a. Each engagement projection 17b of the uneven portion 17 has a square pyramid shape. The uneven portion 17 including the engagement recesses 17a and the engagement projections 17b is an indentation of the tool uneven portion 15 to be explained later, and may have an appropriate shape depending on the shape of the tool uneven portion 15.

The lead frame 11 is connected to the connecting surface 12 in the stacking direction by bonding using laser welding. The lead frame 11 has a rectangular plate shape and is appropriately bent or the like. The lead frame 11 is led out from the connecting surface 12 aside in an intersecting direction with respect to the stacking direction. The lead frame 11 has a gap between the lead frame and the uneven portion 17 in the intersecting direction except for the led-out portion. A thickness of the lead frame 11 in the stacking direction is 0.2mm to 1.2mm. Material of the lead frame 11 is copper, iron, alloy thereof, or the like.

In addition, the shape of the lead frame 11 may be arbitrarily set. Further, the conductive member connected to the connecting surface 12 is not limited to the lead frame 11, and may be another conductive material.

### [Manufacturing Method for Circuit Board]

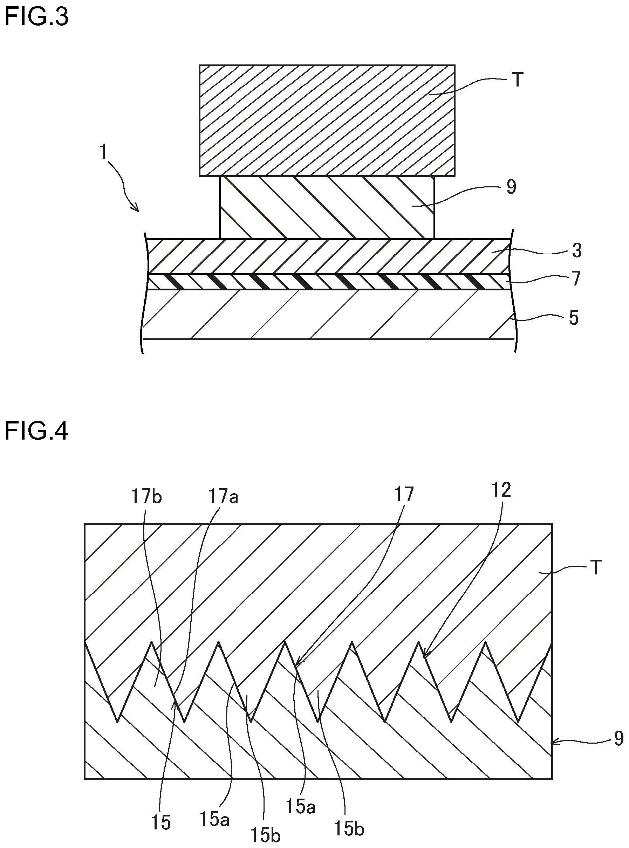

FIG. 3 is a schematic sectional view of a situation in which the additional metal layer 9 is ultrasonically bonded to the circuit pattern 3 according to the embodiment 1. FIG. 4 is an enlarged sectional view of a portion of the tool T of FIG. 3 pressed against the additional metal layer 9.

As illustrated in FIGS. 3 and 4, this manufacturing method uses the tool T. In addition, FIG. 3 illustrates an example in which the tool T with a 12mm square is used for the additional metal layer 9 with a 10 mm square, the tool larger than the additional metal layer. It may use a tool T smaller than the additional metal layer 9.

The tool T has, in a sectional shape, the tool uneven portion 15 corresponding to the uneven portion 17. In the tool uneven portion 15, tool recesses 15a and tool projections 15b are formed corresponding to the engagement projections 17b and the engagement recesses 17a of the uneven portion 17.

In the manufacturing method of the present embodiment using the tool T, the additional metal layer 9 is stacked on the circuit pattern 3. Then, the tool T is pressed against the connecting surface 12 of the additional metal layer 9 and is ultrasonically vibrated. With this, the additional metal layer 9 is bonded onto the circuit pattern 3 by transmission of the ultrasonic vibration. This bonding is performed on the whole bonding surface 10 corresponding to, in the stacking direction, the portion of the connecting surface 12 of the additional metal layer 9 to which the tool T is pressed.

By the pressing with the tool T, the uneven portion 17 is formed on the connecting surface 12 of the additional metal layer 9 according to the tool uneven portion 15 in the present embodiment.

After the additional metal layer 9 is bonded on the circuit pattern 3 in this way, the lead frame 11 is connected to the connecting surface 12 of the additional metal layer 9 as illustrated in FIGS. 1 and 2. In this connection, a portion 14 of the lead frame 11 to be connected is positioned on the connecting surface 12 of the additional metal layer 9. In this state, a laser beam is irradiated over the portion 14 of the lead frame 11 to be connected, to weld the lead frame 11 and the additional metal layer 9.

At this time, laser intensity is set according to the thickness of the lead frame 11. Namely, the laser intensity is set to melt the lead frame 11 having the thickness of 0.2mm to 1.2mm to such an extent that the lead frame is connected to the additional metal layer 9 below the lead frame. The laser intensity is changed according to material of a conductive material such as the lead frame 11, for example, a laser absorption rate or a melting point of the material.

Based on this setting of the laser intensity, the heat at the time of the welding is dispersed by the additional metal layer 9 and the circuit pattern 3 having the thickness of 1.5mm to 3.0mm, to suppress the influence on the insulating layer 7. In addition. the dispersibility of the heat depends on the materials of the additional metal layer 9 and the circuit pattern 3, for example, thermal conductivity of the materials.

### [Experimental Results]

FIG. 5 is a sectional view illustrating an experimental method according to the embodiment 1. As illustrated in FIG. 5, in the experiment, the additional metal layer 9 is bonded to a surface of the circuit pattern 3 with the whole bonding surface 10. Then, welding is performed by irradiation with a laser beam L to the lead frame 11 stacked on the connecting surface 12 of the additional metal layer 9.

At this time, a temperature of a bottom surface of the circuit pattern 3 is measured at a portion TC corresponding to a laser-irradiated portion. The bottom surface of the circuit pattern 3 is a surface located on a side opposite in the stacking direction to the surface on which the laser irradiation of the lead frame 11 is performed.

Material of the lead frame 11 is copper, and thicknesses of the lead frames are set to 0.2mm, 0.5mm, and 1.0mm. Material of the circuit pattern 3 and the additional metal layer 9 is copper. The total thickness of the circuit pattern 3 and the additional metal layer 9 is 0.5mm to 3.0mm. In addition, intensity of a laser is changed to 500W, 750W, and 1300W according to the thicknesses of the lead frames 11, to have the setting to melt the additional metal layer 9 by 0.2mm ± 0.1mm.

FIG. 6 is a graph plotting experimental results of FIG. 5. An ordinate is a peak temperature (circuit bottom surface peak temperature) of the bottom surface of the circuit pattern 3, and an abscissa is the total thickness (total circuit thickness) of the circuit pattern 3 and the additional metal layer 9. In FIG. 6, 0.2mm500W indicates that the thickness of the lead frame 11 is 0.2mm and the intensity of the laser is 500W. The same holds for 0.5mm750W and 1.0mm1300W.

As illustrated in FIG. 6, it suppresses damage to the insulating layer 7 if the thickness of the lead frame 11 is 0.2mm-1.2mm (with the laser intensity set according to the thickness of the lead frame 11) and the total thickness of the additional metal layer 9 and the circuit pattern 3 in the stacking direction is 1.5mm-3.0mm. If the circuit bottom surface peak temperature becomes 105 or more causing damage to the insulating layer 7 when the total circuit thickness is less than 1.5 mm. On the other hand, if the total circuit thickness is 1.5 mm or more, the circuit bottom surface peak temperature is in a range that does not damage the insulating layer 7 up to 3.0 mm being the upper limit of the total thickness. In addition, if the total thickness exceeds 3.0mm, it causes increase in size so that the ultrasonic bonding is difficult and the suppression of the bottom surface temperature tends to be saturated, and it causes a problem that influence of the material thermal resistance is increased or the like. The upper limit of the total thickness is, therefore, set to 3.0 mm.

The insulating layer 7 is made of liquid crystal polymer and contains boron nitride and alumina. Although there is a difference in degree according to heat-resistant temperature of the resin, the insulating layer 7 is more or less damaged when the circuit bottom surface peak temperature becomes about 100. Further, the additional metal layer 9 and the circuit pattern 3 are made of copper as explained above. The range of the total thickness is, however, not greatly varied depending on the materials used for the insulating layer 7 of the circuit board 1, the circuit pattern 3 and the additional metal layer 9.

The circuit board 1 manufactured in this way achieves high quality in which damage to the insulating layer 7 is suppressed even if the heat at the time of the connecting of the lead frame 11 increases, for example, the lead frame 11 is connected to the additional metal layer 9 by laser welding.

### DESCRIPTION OF NUMERALS

- 1: Circuit Board
- 3: Circuit Pattern
- 7: Insulating Layer
- 9: Additional Metal Layer
- 10: Bonding Surface
- 10a: Bonded Portion
- 10b: Un-bonded Portion
- 11: Lead Frame (Conductive Member)
- 12: Connecting Surface (Surface)
- 13: Connection Portion (Surface)
- 15: Tool Uneven Portion
- 17: Uneven Portion

## Claims

1. A circuit board comprising:
a circuit pattern provided on an insulating layer;
an additional metal layer stacked and bonded on the circuit pattern; and
a conductive member stacked and connected on the additional metal layer, wherein
a total thickness of the additional metal layer and the circuit pattern in the stacking direction is 1.5mm to 3.0mm, and
a thickness of the conductive member in the stacking direction is 0.2mm to 1.2mm.

2. The circuit board of claim 1, wherein
a thickness of the additional metal layer in the stacking direction is 0.7mm to 2.7mm, and
a thickness of the circuit pattern in the stacking direction is 0.3mm to 0.8mm.

3. A method for manufacturing a circuit board, the circuit board comprising a circuit pattern provided on an insulating layer, an additional metal layer stacked and bonded on the circuit pattern, and a conductive member stacked and connected on the additional metal layer, wherein a total thickness of the additional metal layer and the circuit pattern in the stacking direction is 1.5mm to 3.0mm, and a thickness of the conductive member in the stacking direction is 0.2mm to 1.2mm, comprising:
stacking the conductive member on the additional metal layer and connecting the conductive member to the additional metal layer by laser welding.

4. The method for manufacturing a circuit board according to claim 3, further comprising:
stacking the additional metal layer on the circuit pattern;
pressing a tool against a surface of the additional metal layer to ultrasonically vibrate to bond the additional metal layer onto the circuit pattern; and
stacking the conductive member on the surface of the additional metal layer bonded on the circuit pattern and connecting the conductive member to the surface of the additional metal layer by laser welding.
